# EUROPEAN PATENT APPLICATION

(11) **EP 1 936 810 A1**
(43) Date of publication of application: **25.06.2008**
(21) Application number: 06026767.1
(22) Date of filing: 22.12.2006
(51) Int. Cl.: H03M 1/46

(54) **Method for analog-to-digital conversion and analog-to-digital converter**

(71) Applicant: austriamicrosystems AG, 8141 Unterpremstätten (AT)
(72) Inventor: Vinau, Jose, 8010 Graz (AT)
(74) Representative: Epping - Hermann - Fischer

(57) **Abstract**

A method for analog-to-digital conversion of an analog input signal (AIN) into a digital output signal (DOUT) uses a successive approximation principle and comprises a first and a second series of steps for a determination of a bit N of the digital output signal (DOUT) as well as a first and a second series of steps for a determination of a further bit N+1 of the digital output signal (DOUT). At least one step of the second series of steps for the determination of the bit N of the digital output signal (DOUT) and at least one step of the first series of steps for the determination of the further bit N+1 of the digital output signal (DOUT) are simultaneously processed.

## Description

The present invention relates to a method for analog-to-digital conversion and to an analog-to-digital converter.

Analog-to-digital converters, abbreviated AD converters, are widely used for connecting analog circuitry to digital circuitry. A successive approximation register principle is common for AD converters.

Document US 4,454,500 shows an AD converter comprising a successive approximation register, abbreviated SAR, for conversion of a plurality of analog signals.

An AD converter with a SAR which comprises an N bit shift register with flip-flops is described in US 4,777,470.

Document US 6,556,164 B2 shows an AD converter, comprising a SAR, a DA converter, a comparator and an acceleration circuit.

It is an object of the present invention to provide a method for analog-to-digital conversion and an analog-to-digital converter achieving a fast conversion of an analog input signal into a digital output signal.

This object is solved by a method for analog-to-digital conversion comprising the features of claim 1 and an analog-to-digital converter according to claim 7. Preferred embodiments are presented in the respective dependent claims.

A method for analog-to-digital conversion, abbreviated AD conversion, of an analog input signal into a digital output signal uses the successive approximation principle. The method comprises a series of steps for determination of a bit N of the digital output signal, which comprises a first series of steps and a second series of steps. The method further comprises a series of steps for determination of a further bit N+1 of the digital output signal, which also comprises a first and a second series of steps. At least one step of the second series of steps which are provided for the determination of the bit N of the digital output signal is simultaneously processed with at least one step of the first series of steps which are provided for the determination of the further bit N+1 of the digital output signal.

It is an advantage of this method that the first and the second series of steps are not processed completely in a serial way, but partly in a parallel way, because at least one step of the second series and one step of the first series are processed in parallel. Therefore, the overall time to gain the complete digital output signal is reduced. It is another advantage of the invention that the reduction of the overall time can be achieved without the need to accelerate a single step of the series of steps.

In an embodiment, a first clock signal and a second clock signal are provided. The first clock signal triggers the first series of steps and the second clock signal triggers the second series of steps.

In an embodiment, the method comprises to provide a register signal which depends on reference data which are stored in a register.

In an embodiment, the method comprises to deliver a digital input signal for a digital-to-analog conversion wherein the digital input signal depends on the register signal.

In an embodiment, the method comprises to provide an analog reference signal which depends on the digital input signal which is gained by the digital-to-analog conversion.

In an embodiment, a comparator output signal is provided which is a result of a comparison of the analog reference signal and the analog input signal. The comparator output signal at a time may comprise the digital value of one bit of the digital output signal.

In a development, the second series of steps comprises to deliver the digital input signal as a function of the register signal and the comparator output signal.

In an alternative development, the first series of steps comprises a parallel processing to provide a first and a second multiplexer input signal. The first or the second multiplexer input signal is selected as a function of the comparator output signal. In an embodiment, a multiplexer output signal is delivered to the register. The multiplexer output signal is the first or the second multiplexer input signal depending on the digital value of the comparator output signal.

According to an embodiment, a method for analog-to-digital conversion of an analog input signal into a digital output signal using successive approximation, comprises a determination of a bit N of the digital output signal with at least two steps and a determination of a further bit N+1 of the digital output signal with at least two steps, wherein a step for the determination of the bit N and a step of the determination of the further bit N+1 are at least partly simultaneously processed.

According to an aspect of the invention, an analog-to-digital converter comprises a logic circuit, a DA converter and a comparator. The logic circuit comprises a first and a second clock input terminal and a first output terminal. The DA converter is coupled on its input side to the logic circuit. The comparator comprises a first and a second input terminal and an output terminal. The first input terminal of the comparator is connected to an output terminal of the DA converter. The output terminal of the comparator is connected to an input terminal of the logic circuit.

A first clock signal and a second clock signal are delivered to the first and the second clock input terminal of the logic circuit. The logic circuit provides a digital input signal to the DA converter. The DA converter delivers an analog reference signal by the digital-to-analog conversion of the digital input signal and provides the analog reference signal to the first input terminal of the comparator. An analog input signal is delivered to the second input terminal of the comparator. The analog input signal is the signal which is converted into the digital output signal by the AD converter. The comparator provides a comparator output signal at its output terminal and delivers the comparator output signal to the input terminal of the logic circuit. The logic circuit is suitable for parallel processing of steps for the determination of the digital output signal.

Parallel processing means a simultaneous processing, wherein the steps of a first series of steps and the steps of a second series of steps are scheduled in such a way that a small overall time for the AD conversion is achieved.

In an embodiment, the logic circuit comprises a control logic, a register and a SAR circuitry. The control logic is connected to the first clock input terminal. The register is coupled on its input side to the control logic and to the second clock input terminal. The SAR circuitry is coupled on its input side to the register and to the output terminal of the comparator. The SAR circuitry is coupled to an input terminal of the DA converter.

In an alternative embodiment, the logic circuit comprises a first and a second SAR circuitry which are both coupled to the first clock input terminal. The logic circuit further comprises a multiplexer which switches the first or the second approximation circuitry to a register. The multiplexer comprises a control terminal which is coupled to the output terminal of the comparator. The register comprises an input terminal which is coupled to the second clock input terminal and an output terminal which is coupled to the DA converter.

In an further development, the logic circuit comprises a control logic which is coupled on the one hand to the first clock input terminal and on the other hand to the first SAR circuitry and the second SAR circuitry.

A parallel processing of steps for AD conversion is achieved by a use of the two clock input terminals and of the first and the second clock signal.

The following description of figures of exemplary embodiments may further illustrate and explain the invention. Devices with the same structure or with the same effect respectively appear with equivalent reference numerals. A description of a part of a circuit or device having the same function in different figures might not be repeated in every of the following figures.
- Figure 1: shows a schematic of an exemplary embodiment of an AD converter,
- Figure 2: shows an exemplary embodiment of a logic circuit for an AD converter,
- Figure 3: shows an alternative exemplary embodiment of a logic circuit for an AD converter,
- Figure 4: shows a further development of the logic circuit which is shown in Figure 3 and a clock generator,
- Figure 5: shows an exemplary embodiment of a control logic,
- Figure 6: shows an exemplary embodiment of a state decoder, and
- Figure 7: shows an exemplary embodiment of a SAR circuitry.

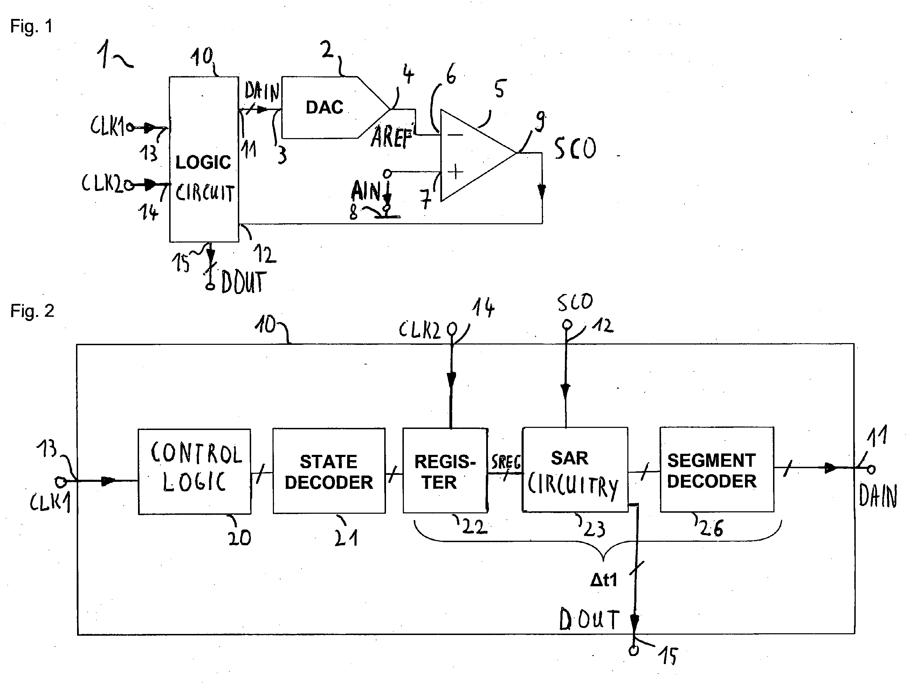

Figure 1 shows an exemplary schematic of an AD converter. The AD converter 1 comprises a logic circuit 10, a digital-to-analog converter 2 and a comparator 5. The logic circuit 10 comprises a first and a second logic input terminal 13, 14, a first and a second output terminal 11, 15 and an input terminal 12. The DA converter 2 comprises an input terminal 3 and an output terminal 4. The input terminal 3 of the DA converter is connected to the first output terminal 11 of the logic circuit 10. The comparator 5 comprises a first and a second input terminal 6, 7 and an output terminal 9. The first input terminal 6 of the comparator 5 is coupled to the output terminal 4 of the DA converter 2. The output terminal 9 of the comparator 5 is connected to the input terminal 12 of the logic circuit 10.

A first clock signal CLK1 and a second clock signal CLK2 are provided to the first and the second clock input terminal 13, 14 of the logic circuit 10. The logic circuit 10 delivers a digital input signal DAIN via its first output terminal 11 to the input terminal 3 of the DA converter 2. The DA converter 2 converts the digital input signal DAIN to an analog reference signal AREF which is delivered via the output terminal 4 of the DA converter 2 to the first input terminal 6 of the comparator 5. An analog input signal AIN is provided to the second input terminal 7 of the comparator 5. The analog input signal AIN has to be converted to a digital output signal DOUT by the AD converter 1. The comparator 5 compares the analog input signal AIN and the analog reference signal AREF and delivers a comparator output signal SCO via its output terminal 9 to the input terminal 12 of the logic circuit 10.

If the analog input signal AIN is larger than the analog reference signal AREF, the comparator output signal SCO has a digital value 1 and, therefore, a corresponding bit of the digital output signal DOUT has the logical value 1. If on the contrary the analog input signal AIN is smaller than the analog reference signal AREF, the comparator output signal SCO has the digital value 0 and, therefore, also the corresponding bit of the digital output signal DOUT has the digital value 0.

The most significant bit and the second most significant bit will be determined in such a way, that the first steps for the determination of the second most significant bit are started before the last steps of the determination of the most significant bit are completed. Using this kind of parallel processing a time for providing all bits of the digital output signal DOUT can be reduced.

Figure 2 shows an exemplary embodiment of the logic circuit 10 which can be inserted in the AD converter 1 shown in Figure 1. The logic circuit 10 comprises a control logic 20, a state decoder 21, a register 22, a SAR circuitry 23 and a segment decoder 26 which are connected in a serial way. The logic circuit 10 further comprises the first and the second clock input terminal 13, 14, the input terminal 12 and the first and the second output terminal 11, 15. The first clock input terminal 13 is coupled to the control logic 20. The register 22 is coupled to the control logic 20 via the state decoder 21. The register 22 is also connected on its input side to the second clock input terminal 14. The SAR circuitry 23 is coupled on its input side to the register 22 and also to the input terminal 12 of the logic circuit 10. On its output side the SAR circuitry 23 is coupled to the first output terminal 11 of the logic circuit 10 via the segment decoder 26 and is coupled to the second output terminal 15 of the logic circuit 10.

The first clock signal 1 triggers the operation of the control logic 20 which is followed by the operation of the state decoder 21. The control logic 20 comprises serially-connected flip-flops. The control logic 20 identifies the steps for the determination of the bit N out of the overall steps for the determination of all bits ranging from the most significant bit to the least significant bit. The state decoder 21 synchronizes these steps by decoding of states provided by the control logic 20. The output terminal of the control logic 20 comprises several bus terminals. The register 22 comprises several cells. Therefore, the state decoder 21 comprises a connection matrix with lines which connect the different bus terminals of the output terminal of the control logic 20 to the cells of the register 22. The logical values of reference data stored by the cells of the register 22 depend on the signals provided by the control logic 20 and the state decoder 21. The second clock signal CLK2 triggers the operation of the register 22 which delivers a register signal SREG to the SAR circuitry 23 which comprises several SAR cells. The comparator output signal SCO is provided to the SAR circuitry 23. Using the register signal SREG, one SAR cell out of the several SAR cells is selected to which the corresponding logical value of the comparator output signal SCO is written. Depending on the logical values stored in the SAR cells the SAR circuitry 23 delivers the digital input signal DAIN with the use of the segment decoder 26. The digital input signal DAIN is directed to the input terminal 3 of the DA converter 2 via the first output terminal 11 of the logic circuit 10. The segment decoder 26 comprises a connection matrix with lines which connect different bus terminals of the output terminal of the SAR circuitry 23 to the bus terminals of the input terminal 3 of the DA converter 2. The digital values stored in the SAR cells of the SAR circuitry 23 are provided at the second output terminal 15 of the logic circuit 10 in the form of the digital output signal DOUT at the end of the AD conversion. The digital output signal DOUT comprises a number L of bits.

While the DA converter 2 and the comparator 5 are operating, the next cycle of the first clock signal CLK1 can start and the control logic 20 and the state decoder 21 can be perform the steps for the determination of the next bit of the digital output signal DOUT. A first delay time Δt1 comprises the operation of the register 22, the SAR circuitry 23 and the segment decoder 26.

In an alternative embodiment, the control logic 20 comprises a state machine. In another embodiment, the control logic 20 comprises a microprocessor.

In an alternative embodiment, the SAR circuitry 23 comprises a state machine.

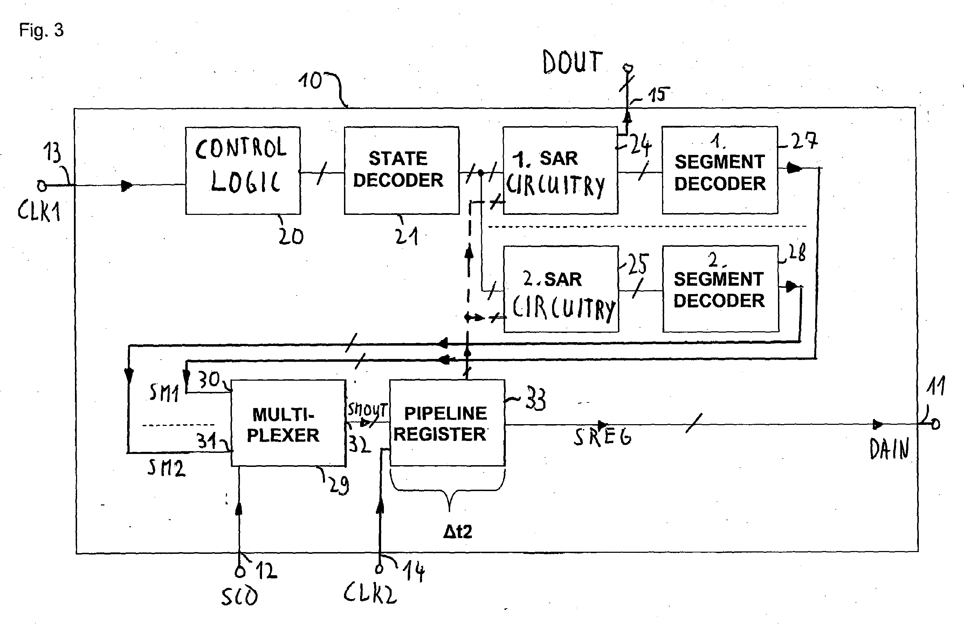

Figure 3 shows an alternative embodiment of a logic circuit 10 which can be inserted into the AD converter 1 shown in Figure 1. The logic circuit 10 comprises a control logic 20 and a state decoder 21 which are connected in a serial way. The first clock input terminal 13 is coupled to an input terminal of the control logic 20. The logic circuit 10 further comprises a first and a second SAR circuitry 24, 25, a first and a second segment decoder 27, 28 and a multiplexer 29. An input terminal of the first SAR circuitry 24 and an input terminal of a second SAR circuitry 25 are coupled to the control circuit 20 via the state decoder 21. An output terminal of the first SAR circuitry 24 is coupled to a first input terminal 30 of the multiplexer 29 via the first segment decoder 27. An output terminal of the second SAR circuitry 25 is similarly coupled to a second input terminal 31 of the multiplexer 29 via the second segment decoder 28. The logic circuit 10 further comprises a pipeline register 33 which is arranged between an output terminal 32 of the multiplexer 29 and the first output terminal 11 of the logic circuit 10. The multiplexer 29 comprises a control terminal which is coupled to the input terminal 12 of the logic circuit 10 and, therefore, is coupled to the output terminal 9 of the comparator 5. The pipeline register 33 comprises a further input terminal which is connected to the second clock input terminal 14. Another output terminal of the SAR circuitry 24 is connected to the second output terminal 15 of the logic circuit 10.

The first logic signal CLK1 is provided to the control logic 20 so that the control logic 20 generates a signal for the first and the second SAR circuitry 24, 25 using the state decoder 21. The control logic 20 comprises a serial circuit of flip-flops. The first SAR circuitry 24 comprises several cells. The second SAR circuitry 24 comprises the same number of cells. The state decoder 21 comprises a connection matrix with lines which connect the output terminal of the control logic 20 which comprises different bus terminals to the input terminal of the first and to the input terminal of the second SAR circuitry 24, 25 which each comprise also several bus terminals. The first and the second SAR circuitry 24, 25 are operating in parallel and deliver a first and a second multiplexer input signal SM1, SM2 via the first and the second segment decoders 27, 28 to the first and the second input terminals 30, 31 of the multiplexer 29. The output terminal of the first and the second SAR circuitry 24, 25 each comprises several bus terminals. The first and the second input terminals 30, 31 of the multiplexer 29 also comprise several bus terminals. The first and the second segment decoder 27, 28 connect the several bus terminals of the output terminal of the first and the second SAR circuitry 24, 25 to the several bus terminals of the first and the second input terminals 30, 31 of the multiplexer 29. Depending on the comparator output signal SCO which is provided to the input terminal 12 of the logic circuit 10 and, therefore, to the control terminal of the multiplexer 29, the first or the second multiplexer input signal SM1, SM2 is selected, so that the multiplexer 29 can generate a multiplexer output signal SMOUT at its output terminal 32. The signal SMOUT will be further processed by the pipeline register 33 in case that the second clock signal CLK2 triggers the operation of the pipeline register 33. After having started operation of the pipeline register 33 a register signal SREG will be generated which has a second delay time ΔT2 in comparison to the second clock signal CLK2. The register signal SREG at the output terminal of the pipeline register 33 is provided as the digital input signal DAIN to the first output terminal 11 of the logic circuit 10 and, therefore, to the input terminal 3 of the DA converter 2. Connections inside the logic circuit 10 between the control logic 20 and the first output terminal 11 of the logic circuit 10 comprise several parallel bus connections.

A first series of steps comprises the operation of the control logic 20, the state decoder 21, the first and the second SAR circuitry 24, the first and the second segment decoder 27, 28 and the multiplexer 29. A second series of steps comprises an operation of the pipeline register 33, the DA converter 2 and the comparator 5. While the first series of steps is triggered by the first clock signal 1, the second series of steps is triggered by the second clock signal CLK2. In an embodiment, the time for the second series of steps is larger than the time for the first series of steps, because the DA conversion and the comparison of the analog signals are time consuming. This is especially the case for the most significant bit and the following bits because the analog reference signal AREF may show large changes. During the time in which the DA converter 2 and the comparator 5 are operating, the next cycle of the first clock signal CLK1 can start so that the control logic 20, the state decoder 21, the first and the second SAR circuitry 24, 25 and the first and the second segment decoders 27, 28 can operate to generate their respective output signals. As soon as the comparator 2 has generated the comparator output signal SCO, the second clock signal CLK2 triggers the next cycle of the second series of steps, so that the data of the multiplexer output signal SMOUT are stored by the pipeline register 33 as the reference data and are also switched to the DA converter 2. The second clock signal CLK2 acts as a control signal for this switching operation.

It is an advantage that the logic circuit 10 can perform several steps which are necessary for the determination of the further bit N+1 of the digital output signal DOUT, before the comparator output signal SCO which comprises the digital value for the bit N of the digital output signal DOUT is available. This is achieved by the parallel processing in the first and the second SAR circuitry 24, 25 for the preparation of the next digital input signal DAIN without knowing the value of the comparator output signal SCO for the former bit. By this multi-thread architecture calculations are simultaneously performed for the two possible values of the comparator output signal SCO.

In an alternative embodiment, the control logic 20 comprises a state machine. In another embodiment, the control logic 20 comprises a microprocessor.

In an alternative embodiment, the pipeline register 33 is coupled to the first and the second SAR circuitry 24, 25 so that the reference data stored in the cells of the pipeline register 33 can be used to update the data stored by the SAR cells in the first and the second SAR circuitry 24, 25. This coupling is indicated by a dashed line.

In an alternative embodiment, the second SAR circuitry 25 uses the cells which are comprised by the first SAR circuitry 24, so that the chip area for the AD converter 1 is reduced.

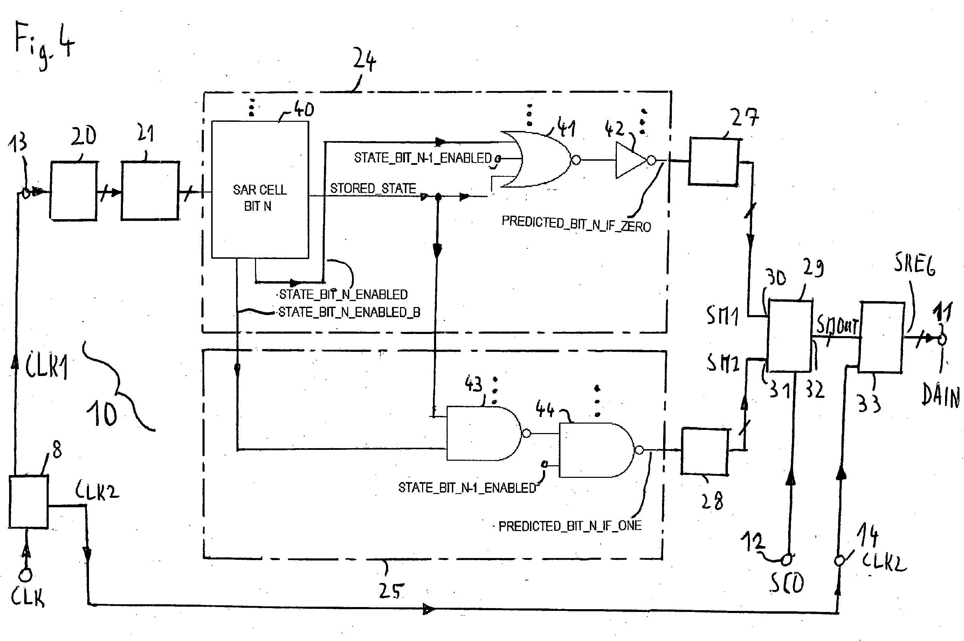

Figure 4 shows an exemplary embodiment of a logic circuit 10 which is a further development of the logic circuit 10 shown in Figure 3. The first SAR circuitry 24 comprises a SAR cell 40, an NOR gate 41 and an inverter 42 at least. The SAR cell 40 is coupled to the logic circuit 20 via the state decoder 21. The input terminals of the NOR gate 41 are coupled to the SAR cell 40. The inverter 42 is arranged between an output terminal of the NOR gate 41 and the first segment decoder 27. Since the digital output signal comprises the first number L of bits, the first SAR circuitry 24 comprises the first number L of SAR cells 40, the first number L of NOR gates 41 and the first number L of inverters 42. The input terminals of the SAR cells 40 are connected to the bus output terminals of the state decoder 21. The second SAR circuitry 25 comprises at least a first NAND gate 43 which is coupled on its input side to the SAR cell 40 of the first SAR circuitry 24 and on its output side via a second NAND gate 44 to the second segment decoder 28. Also the second SAR circuitry 25 comprises the first number L of first NAND gates 43 and the first number L of second NAND gates 44.

The AD converter 1 comprises a clock generator 8 which is coupled to the logic circuit 10. An output terminal of the clock generator 8 is coupled to the first clock input terminal 13 and another output terminal of the clock generator 8 is coupled to the second clock input terminal 14. Such a clock generator 8 my also be inserted in the arrangements shown in Figure 1 to 3.

A clock signal CLK is provided to an input terminal of the clock generator 8 which generates the first and the second clock signal CLK1, CLK2. The first and the second clock signal CLK1, CLK2 have the same frequency, but a different phase.

Each of the first number L of SAR cells 40 provides a signal STORED_STATE, a signal STATE_BIT_N_ENABLED and a signal STATE_BIT_N_ENABLED_B. The signals are delivered to the NOR gates 41, the first NAND gates 43 and the second NAND gates 44. The NOR gate 41 has three inputs to which the signals STORED_STATE, STATE_BIT_N_ENABLED and STATE_BIT_N-1_ENABLED are delivered to. At the output of the inverter 42 a signal PREDICTED_BIT_N_IF_ZERO is provided. The first NAND gate 43 comprises two input terminals to which the signals STORED_STATE and STATE_BIT_N_ENABLED_B are delivered to. The output terminal of the first NAND gate 43 is connected to an input terminal of the second NAND gate 44. The second NAND gate 44 comprises a further input terminal to which the signal STATE_BIT N-1_ENABLED is delivered to. At the output terminal of the second NAND gate 44 a signal PREDICTED_BIT_N_IF_ONE is provided.

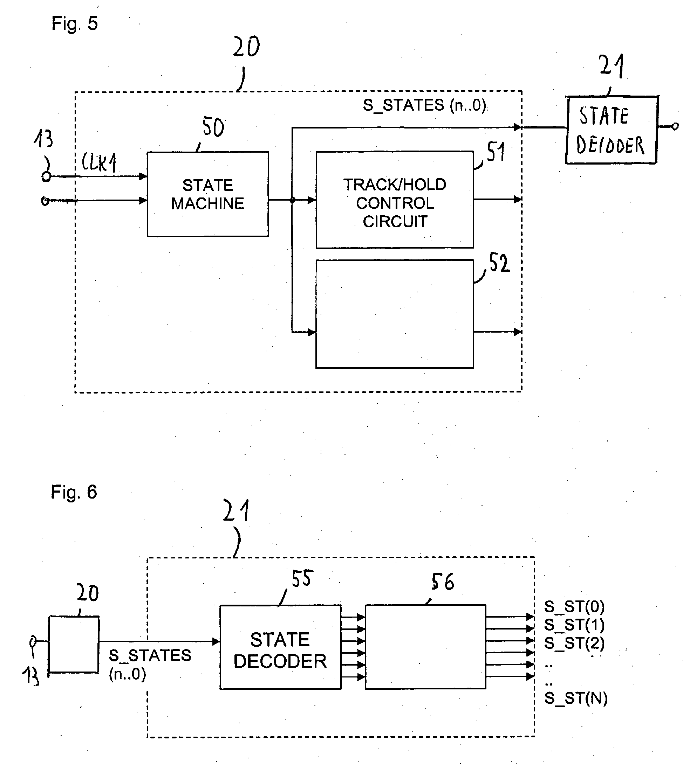

Figure 5 shows an exemplary embodiment of a control logic 20 which can be inserted in the logic circuit 10 shown in Figure 2 or 3. The control logic 20 comprises a state machine 50 which is arranged between the first clock input terminal 13 and the state decoder 21. The control logic 20 further comprises a track/hold circuit 51 with an input terminal which is connected to the output terminal of the state machine 50 and with an output terminal. In addition, the control logic 20 comprises an additional control logic 52 with an input terminal which is connected to the output terminal of the state machine 50 and with an output terminal.

The state machine 50 generates the state signals S_STATES(n..0) using the first clock signal CLK1. The state signals S_STATES(n..0) are provided to the state decoder 21. The track/hold circuit 51 generates track/hold signals depending on the state signals S_STATES(n..0). The state signals S_STATES(n..0) are also applied to the additional control logic 52 which generates further control signals for the synchronization with other blocks and for the synchronization of phases.

In an alternative embodiment, the additional control logic 52 generates control signals for a test mode of the AD converter 1.

Figure 6 shows an exemplary embodiment of a state decoder 21 which can be inserted in the logic circuit 10 shown in Figure 2 or 3. The state decoder 21 comprises a first state decoder 55 and a glitches eliminator circuit 56 which are arranged in a serial circuit between an input terminal of the state decoder 21 and an output terminal of the state decoder 21. The input terminal of the state decoder 21 is connected to the control logic 20.

The first state decoder 55 decodes the state signals S_STATES(N..0) and provides the signals S_ST(0), S_ST(1), S_ST(2), ... , S_ST(N) so that the information comprised by the state signals S_STATES(N..0) can be provided to the other parts of the logic circuit 10 and of the AD converter 1. The glitches eliminator circuit 56 eliminates glitches of the signals S_ST(0), S_ST(1), S_ST(2), ... , S_ST(N) in between states that may trigger unwanted events.

In case that the state decoder 21 is inserted in the logic circuit 10 according to Figure 2, the output terminals of the glitches eliminator circuit 56 are connected to the register 22. The signals S_ST(0), S_ST(1), S_ST(2), ... , S_ST(N) are applied to the register 22.

In case that the state decoder 21 is inserted in the logic circuit 10 according to Figure 3, the output terminals of the glitches eliminator circuit 56 are connected to the first and the second SAR circuitry 24, 25. The signals S_ST(0), S_ST(1), S ST(2), ... , S_ST(N) are applied to the first and the second SAR circuitry 24, 25.

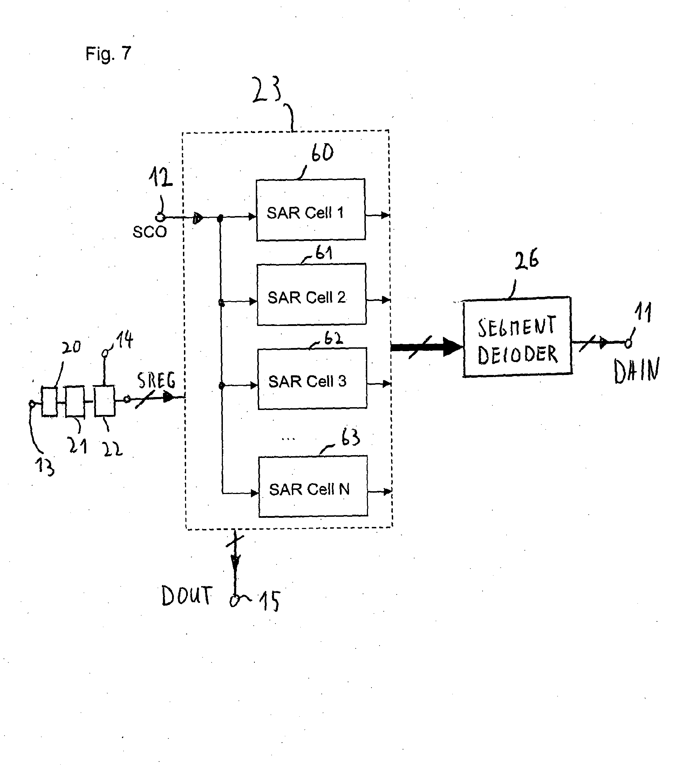

Figure 7 shows an exemplary embodiment of a SAR circuitry 23 which can be inserted in the logic circuit 10 shown in Figure 2. The SAR circuitry 23 comprises several SAR cells 60, 61, 62, 63. The number of SAR cells 60, 61, 62, 63 can be N where N is the number of bits. The SAR cells 60, 61, 62, 63 are connected in parallel and are arranged between the input terminal 12 of the logic circuit 10 and the segment decoder 26. On their input side, the SAR cells 60, 61, 62, 63 are also coupled to the control logic 20. On their output side, the SAR cells 60, 61, 62, 63 are additionally coupled to the second output terminal 15 of the logic circuit 10.

A SAR cell of the SAR cells 60, 61, 62, 63 activates its output for the trial of the corresponding bit. A SAR cell of the SAR cells 60, 61, 62, 63 also stores the corresponding value of the comparator output signal SCO which is generated by the comparator 5. A SAR cell of the SAR cells 60, 61, 62, 63 provides the corresponding value of the digital output signal DOUT to the second output terminal 15. The value of the digital output signal DOUT depends on the corresponding stored value of the comparator output signal SCO.

In an embodiment, the state decoder 21 and the register 22 couple the control logic 20 to the SAR cells 60, 61, 62, 63. The SAR cells 60, 61, 62, 63 receive the register signal SREG.

In an embodiment, the segment decoder 26 is designed as a thermometer decoder. The segment decoder 26 operates as a thermometer decoder.

### Reference numerals

- 1: AD converter
- 2: DA converter
- 3: input terminal
- 4: output terminal
- 5: comparator
- 6: first input terminal
- 7: second input terminal
- 8: clock generator
- 9: output terminal
- 10: logic circuit
- 11: first output terminal
- 12: input terminal
- 13: first clock input terminal
- 14: second clock input terminal
- 15: second output terminal
- 20: control logic
- 21: state decoder
- 22: register
- 23: SAR circuitry
- 24: first SAR circuitry
- 25: second SAR circuitry
- 26: segment decoder
- 27: first segment decoder
- 28: second segment decoder
- 29: multiplexer
- 30: first input terminal
- 31: second input terminal
- 32: output terminal
- 33: pipeline register
- 40: SAR cell
- 41: NOR gate
- 42: inverter
- 43: first NAND gate
- 44: second NAND gate
- AIN: analog input signal
- AREF: analog reference signal
- CLK: clock signal
- CLK1: first clock signal
- CLK2: second clock signal
- DAIN: digital input signal
- DOUT: digital output signal
- SCO: comparator output signal
- SM1: first multiplexer input signal
- SM2: second multiplexer input signal
- SMOUT: multiplexer output signal
- SREG: register signal
- ΔT1: first delay time
- ΔT2: second delay time

## Claims

1. Method for analog-to-digital conversion of an analog input signal (AIN) into a digital output signal (DOUT) using successive approximation,
comprising a first and a second series of steps for a determination of a bit N of the digital output signal (DOUT) and a first and a second series of steps for a determination of a further bit N+1 of the digital output signal (DOUT), wherein
- at least one step of the second series of steps for the determination of the bit N of the digital output signal (DOUT) and
- at least one step of the first series of steps for the determination of the further bit N+1 of the digital output signal (DOUT)
are simultaneously processed.

2. Method according to claim 1,
comprising providing a first and a second clock signal (CLK1, CLK2), wherein the first series of steps is controlled by the first clock signal (CLK1) and the second series of steps is controlled by the second clock signal (CLK2).

3. Method according to claim 1 or 2,
wherein the first series of steps comprises
- identifying the first series of steps for the determination of the bit N out of the first series of steps for the determination of the most significant bit up to the first series of steps for the determination of the least significant bit by a control logic (20) and
- synchronizing of the first series of steps for the determination of the bit N by a state decoder (21).

4. Method according to one of claims 1 to 3,
wherein the second series of steps comprises
- providing a register signal (SREG) depending on reference data stored in a register (22, 33),
- providing a digital input signal (DAIN) to a digital-to-analog converter (2) depending on the register signal (SREG),
- providing an analog reference signal (AREF) by the digital-to-analog converter (2) depending on the digital input signal (DAIN) and
- providing a comparator output signal (SCO) depending on a comparison of the analog reference signal (AREF) and the analog input signal (AIN).

5. Method according to claim 4,
wherein the second series of steps comprises providing the digital input signal (DAIN) depending on the register signal (SREG) and the comparator output signal (SCO).

6. Method according to claim 4,
wherein the first series of steps comprises
- providing a first multiplexer input signal (SM1) and a second multiplexer input signal (SM2),
- selecting the first or the second multiplexer input signal (SM1, SM2) depending on the comparator output signal (SCO) and
- providing a multiplexer output signal (SMOUT) to an input terminal of the register (33) depending on the selection of the first or the second multiplexer input signal (SM1, SM2).

7. Analog-to-digital converter, comprising
- a logic circuit (10), comprising a first and a second clock input terminal (13, 14) to which a first and a second clock signal (CLK1, CLK2) are provided,
- a digital-to-analog converter (2) which is coupled to a first output terminal (11) of the logic circuit (10),
- a comparator (5), comprising
- a first input terminal (6) which is coupled to the digital-to-analog converter (2),
- a second input terminal (7) to which an analog input signal (AIN) is provided and
- an output terminal (9) which is coupled to the logic circuit (10),
wherein the logic circuit (10) is designed for simultanous processing of steps for a determination of a digital output signal (DOUT).

8. Analog-to-digital converter according to claim 7,
wherein the logic circuit (10) is designed for processing of
- a first series of steps, controlled by the first clock signal (CLK1) and processed for the determination of a bit N of the digital output signal (DOUT), and
- a second series of steps, controlled by the second clock signal (CLK2) and processed for the determination of the bit N of the digital output signal (DOUT).

9. Analog-to-digital converter according to claim 8,
wherein the logic circuit (10) is designed for processing of
- a first series of steps controlled by a further cycle of the first clock signal (CLK1) and processed for the determination of a further bit N+1 of the digital output signal (DOUT) and
- a second series of steps controlled by a further cycle of the second clock signal (CLK2) and processed for the determination of the further bit N+1 of the digital output signal (DOUT),
wherein
- at least one step of the second series of steps for the determination of the bit N of the digital output signal (DOUT) and
- at least one step of the first series of steps for the determination of the further bit N+1 of the digital output signal (DOUT)
are simultaneously processed.

10. Analog-to-digital converter according to one of claims 7 to 9,
wherein the logic circuit (10) comprises
- a control logic (20) which is coupled on its input side to the first clock input terminal (13),
- a register (22) which is coupled on its input side to the second clock input terminal (14) and to the control logic (20),
- a successive approximation register circuitry (23) which is coupled to an output terminal of the register (22) and to the output terminal (9) of the comparator (5) and which is coupled on its output side to the digital-to-analog converter (2).

11. Analog-to-digital converter according to one of claims 7 to 9,
wherein the logic circuit (10) comprises
- a first successive approximation register circuitry (24) which is coupled to the first clock input terminal (13),
- a second successive approximation register circuitry (25) which is coupled to the first clock input terminal (13),
- a multiplexer (29) which is coupled on its input side to the first successive approximation register circuitry (24), the second successive approximation register circuitry (25), and the output terminal (9) of the comparator (5),
- a register (33) which is coupled on its input side to an output terminal (32) of the multiplexer (29) and to the second clock input terminal (14) and which is coupled on its output side to the digital-to-analog converter (2).

12. Analog-to-digital converter according to claim 11,
wherein the logic circuit (10) comprises a control logic (20) which is arranged between the first clock input terminal (13) and the first successive approximation register circuitry (24) and between the first clock input terminal (13) and the second successive approximation register circuitry (25).

13. Analog-to-digital converter according to claim 11 or 12,
wherein
- the first successive approximation register circuitry (24) comprises a NOR-gate (31) and
- the second successive approximation register circuitry (25) comprises a NAND-gate (32).
